Europäisches Patentamt

European Patent Office

Office européen des brevets

(19)

(11) **EP 0 723 341 A1**

(12) # DEMANDE DE BREVET EUROPEEN

(43) Date de publication:
**24.07.1996 Bulletin 1996/30**

(51) Int Cl.$^6$: **H03M 7/30**

(21) Numéro de dépôt: **96200089.9**

(22) Date de dépôt: **15.01.1996**

(84) Etats contractants désignés:
**DE FR GB**

(30) Priorité: **18.01.1995 FR 9500529**

(71) Demandeurs:
- **LABORATOIRES D'ELECTRONIQUE PHILIPS S.A.S.**
  **94450 Limeil-Brévannes (FR)**
  Etats contractants désignés:
  **FR**
- **Philips Electronics N.V.**
  **5621 BA Eindhoven (NL)**
  Etats contractants désignés:
  **DE GB**

(72) Inventeurs:
- **Aglan, Afaf, Société Civile S.P.I.D.**
  **F-75008 Paris (FR)**
- **Auge, Ivan, Société Civile S.P.I.D.**
  **F-75008 Paris (FR)**

(74) Mandataire: **Chaffraix, Jean**
**Société Civile S.P.I.D.**
**156, Boulevard Haussmann**
**75008 Paris (FR)**

(54) **Système de compression de données**

(57) L'invention concerne un système comportant des moyens de compression/décompression d'un flux de données. Ces moyens consistent notamment à découper ledit flux en chaînes de caractères, construire un dictionnaire associant un code à chacune desdites chaînes, et délivrer un flux comprimé constitué à partir desdits codes.

Conformément à l'invention:

- chaque code est constitué par l'adresse dans le dictionnaire de la chaîne à laquelle il est associé,

- un nombre restreint d'emplacements est essayé pour l'enregistrement d'une chaîne dans le dictionnaire,

- le dictionnaire est mis à jour continûment,

- différents dictionnaires sont mis en concurrence sans augmentation de la quantité de données à transmettre, l'un de ces dictionnaires étant avantageusement un dictionnaire de taille nulle utilisé pour délivrer des données sans compression.

Applications: systèmes de transmission ou de stockage de données, notamment.

| | Sf | Pf | F |
|---|---|---|---|
| h(A) | A | - | 1 |
| h(AB) | B | h(A) | 1 |
| h(B) | B | - | 1 |
| h(BA) | A | h(B) | 1 |
| h(ABA) | A | h(AB) | 0 |
| h(C) | C | - | 1 |
| h(BAC) | C | h(BA) | 0 |
| h(CA) | A | h(C) | 0 |

**FIG. 7**

EP 0 723 341 A1

## Description

La présente invention concerne un système de compression/décompression comportant:

- un accès pour recevoir un flux de données,
- des moyens de compression dudit flux de données formés de moyens de découpage dudit flux de données en chaînes de caractères et de moyens de construction d'un dictionnaire associant un code à chacune desdites chaînes de caractères,
- des moyens de délivrance sur un support intermédiaire d'un flux comprimé constitué à partir desdits codes,
- des moyens de décompression du flux de données en provenance dudit support intermédiaire,
- un accès pour fournir le flux de données décomprimé.

L'invention s'applique notamment à des systèmes de transmission ou de stockage de données.

L'invention concerne également un émetteur destiné à transmettre un flux de données comportant:

- des moyens de compression dudit flux de données formés de moyens de découpage dudit flux de données en chaîne de caractères,
- et de moyens de construction d'un dictionnaire associant un code à chacune desdites chaînes de caractères.

L'invention concerne enfin un récepteur destiné à recevoir un flux de données préalablement découpé en chaînes de caractères pour être comprimé, et qui comporte des moyens de décompression.

La procédure de codage LZW (Lempel-Ziv-Welch) est une procédure de compression/décompression bien connue qui est notamment décrite dans la recommandation V42bis du CCITT relative à la commutation de données sur le réseau téléphonique. Elle consiste à construire à partir d'un flux de données un dictionnaire de chaînes de caractères et à rechercher dans ce dictionnaire la chaîne la plus longue possible de façon à transmettre ou à stocker le code associé à cette chaîne au lieu de la chaîne elle-même. La compression réside dans le fait qu'un seul code peut représenter une chaîne de plusieurs caractères.

Une telle procédure présente toutefois l'inconvénient de nécessiter l'utilisation d'un dictionnaire de compression de taille relativement importante puisqu'il doit contenir pour chaque chaîne de caractères enregistrée, d'une part la chaîne elle-même et d'autre part le code qui lui est associé. Ce problème est particulièrement crucial pour les applications réseaux car il est alors nécessaire d'utiliser autant de dictionnaires qu'il y a de communications en cours.

L'invention a notamment pour but de proposer un système de compression/décompression qui remédie à cet inconvénient.

Pour cela un système de compression/décompression selon l'invention et tel que décrit dans le paragraphe introductif est caractérisé en ce que ledit code est constitué par l'adresse dans le dictionnaire de la chaîne de caractères associée.

Dans un mode de réalisation particulièrement intéressant d'un système de compression/décompression selon l'invention, lesdits moyens de construction du dictionnaire sont notamment formés:

- de moyens pour attribuer à une chaîne un premier emplacement dans le dictionnaire,
- de moyens pour rechercher un nombre limité d'emplacements de replis dans le cas où ledit premier emplacement ne serait pas disponible.

Ce mode de réalisation présente l'avantage de permettre de garantir un temps de traitement maximum limité en cas de collision pour l'attribution d'un emplacement dans le dictionnaire. Cette caractéristique est d'autant plus importante que la taille du dictionnaire est fixe, ce qui est préconisé dans un système selon l'invention puisque les codes associés aux chaînes de caractères enregistrées dans le dictionnaire sont attribués aléatoirement et non séquentiellement comme c'est le cas dans une procédure de codage classique. Cette caractéristique est particulièrement avantageuse dans le cas des applications réseaux, puisqu'elle garantit alors un débit minimum.

Dans un autre mode de réalisation avantageux d'un système selon l'invention, lesdits moyens de construction du dictionnaire sont de plus formés:

- de moyens pour enregistrer chaque chaîne dans le dictionnaire sous forme d'un suffixe et d'un préfixe constitué par un pointeur vers un autre élément du dictionnaire,
- de moyens pour associer de plus à chaque chaîne de caractères le nombre de ses fils,
- et de moyens pour rechercher dans le dictionnaire, lorsque pour une nouvelle chaîne de caractères aucun des emplacements de replis n'est disponible, une chaîne de caractères qui n'a pas de fils afin de la remplacer par ladite nouvelle chaîne de caractères.

Il est ainsi possible de faire une mise-à-jour en continu du dictionnaire, ce qui permet d'éviter toute réinitialisation et donc d'éviter les baisses de taux de compression temporaires qui résulteraient de telles réinitialisations.

Enfin, dans un autre mode de réalisation d'un système selon l'invention, lesdits moyens de compression comportent une pluralité de dictionnaires construits en parallèle, des moyens de comparaison régulière de l'efficacité de chacun d'eux sur les données traitées, et des moyens de sélection du dictionnaire le plus efficace, dit dictionnaire maître, pour délivrer ledit flux comprimé à venir; et le moyens de décompression sont notamment formés de moyens de mise à jour en parallèle de chacun des dictionnaires qui reprennent les moyens de découpage du flux de données et de construction desdits dictionnaires utilisés pour la compression, de moyens de comparaison régulière de l'efficacité de chacun d'eux sur les données traitées,

et de moyens de sélection du dictionnaire maître pour décomprimer les données à venir.

Un tel système présente l'avantage de permettre un choix du dictionnaire de compression sans impliquer l'émission d'un code de contrôle pour indiquer les changements de dictionnaires à la fonction décompression, c'est-à-dire sans augmentation de quantité de données à transmettre.

Un tel système peut également être mis en place indépendamment des caractéristiques de l'invention décrites ci-dessus, c'est-à-dire indépendamment de la structure utilisée pour les dictionnaires, et indépendant des méthodes de traitement des collisions et de mise à jour utilisées. Toutefois, il est particulièrement avantageux lorsque la taille des dictionnaires utilisés est réduite puisqu'il entraîne une multiplication des dictionnaires utilisés.

Un tel système comporte de façon avantageuse un dictionnaire de taille nulle utilisé pour délivrer des données sans compression.

Lorsque différents dictionnaires sont ainsi mis en concurrence, il est particulièrement avantageux de réaliser ledit système aux moyens de circuits ASIC spécifiques de façon à obtenir un débit plus élevé.

D'autres particularités, détails et avantages de la présente invention apparaîtront dans la description qui va suivre er référence aux dessins annexés qui sont donnés à titre d'exemple non limitatif et dans lesquels:

- la figure 1 est un organigramme d'une procédure de compression de type LZW selon l'art antérieur,
- la figure 2 décrit un exemple d'application d'une telle procédure,
- la figure 3 représente l'état du dictionnaire à la suite de la compression du flux de données considéré dans l'exemple de la figure 2,
- la figure 4 est un organigramme d'une procédure de décompression de type LZW selon l'art antérieur,
- la figure 5 décrit un exemple d'application d'une telle procédure de décompression,
- la figure 6 représente l'état du dictionnaire de décompression à la suite de l'opération de décompression décrite sur la figure 5,
- la figure 7 représente la structure d'un dictionnaire selon l'invention,
- la figure 8 représente schématiquement un système selon l'invention mettant en concurrence différents dictionnaires,
- la figure 9 représente un organigramme d'une procédure de compression de données selon l'invention,
- la figure 10 représente un organigramme d'une procédure de décompression de données selon l'invention,
- la figure 11 représente un système de transmission de données selon l'invention,
- la figure 12 représente schématiquement un système de stockage de données selon l'invention.

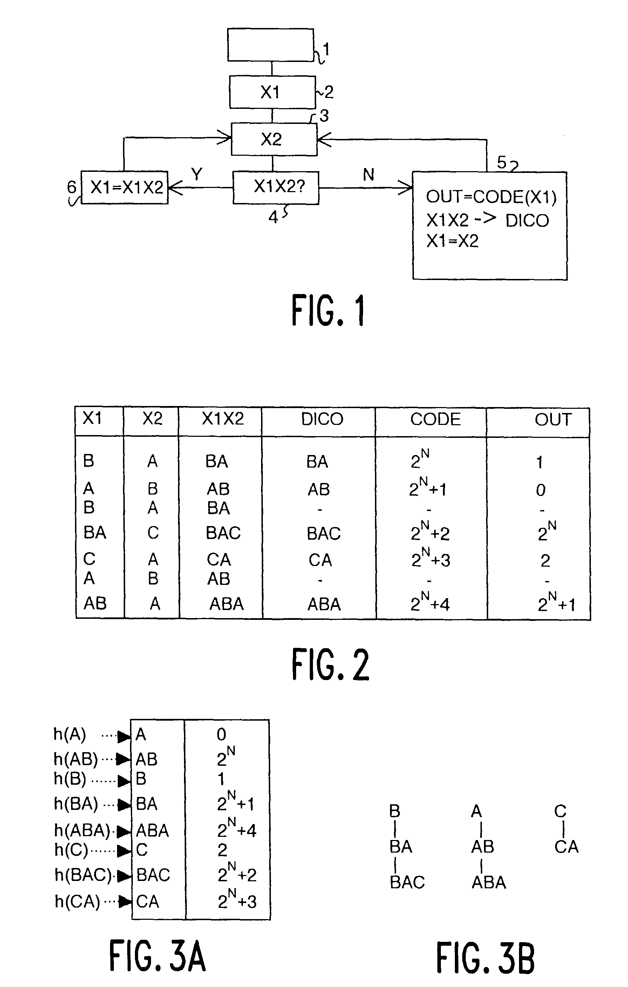

Les principes de base d'une procédure de compression/décompression telle que décrite dans la recommandation V42bis du CCITT vont tout d'abord être rappelés en se référant aux figures 1 à 6.

La figure 1 est un organigramme d'une procédure de compression de type LZW. Conformément à la figure 1, les étapes fondamentales d'une telle procédure sont les suivantes:

- L'étape 1 correspond à un enregistrement préalable des $2^N$ caractères de l'alphabet dans le dictionnaire (où N correspond au nombre de bits utilisés pour coder chaque caractère). Et un compteur CPT est initialisé à la valeur $2^N$.
- L'étape 2 consiste à lire le premier caractère du flux de données qui est affecté à une variable X1.
- L'étape 3 consiste à lire le caractère suivant du flux de données qui est affecté à une variable X2.
- A l'étape 4 la chaîne de caractères X1X2 est formée, et recherchée dans le dictionnaire. Si elle n'y figure pas, la procédure se poursuit à l'étape 5.
- L'étape 5 consiste à inscrire la chaîne X1X2 dans le dictionnaire en lui associant un code égal au contenu du compteur CPT. Puis le compteur CPT est incrémenté, le code associé au contenu de la variable X1 est délivré en sortie, et le contenu de la variable X2 est affecté à la variable X1. La procédure reprend alors à l'étape 3. Dans la pratique, il est connu de déterminer l'emplacement d'une chaîne dans le dictionnaire en fonction du contenu de ladite chaîne. Pour cela, une fonction couramment appelée fonction de hachage et notée "h" dans la suite de l'exposé est appliquée à la chaîne X1X2 pour fournir son emplacement h(X1X2) dans le dictionnaire.
- L'étape 6 gère le cas où la chaîne X1X2 est trouvée dans le dictionnaire. Dans ce cas la chaîne X1X2 est affectée à la variable X1 et la procédure reprend à l'étape 3.

La figure 2 décrit un exemple d'application d'une telle procédure pour un flux de données d'entrée constitué des caractères "BABACABA". Les caractères A, B et C sont préalablement enregistrés dans le dictionnaire aux adresses h(A), h(B) et h(C), et les codes 0, 1 et 2 leur sont respectivement associés. Puis, les caractères B et A sont respectivement affectés aux variables X1 et X2. La chaîne BA est recherchée dans le dictionnaire, et comme elle n'y figure pas, elle y est enregistrée à une adresse h(BA) en association avec le code $2^N$. Le compteur CPT est incrémenté, le code "1" associé au caractère B est délivré en sortie et le caractère A est affecté à la variable X1. Le caractère suivant B du flux de données est affecté à la variable X2 et la chaîne AB est recherchée dans le dictionnaire. Elle n'y figure pas, et y est donc enregistrée à l'adresse h(AB) en association avec le code $2^N+1$. Le compteur CPT est incrémenté, le code "0" associé au caractère A est délivré en sortie et le caractère B est affecté à la variable X1. Le caractère suivant A du flux de données est affecté à la variable X2 et la chaîne BA est trouvée dans le dictionnaire. Elle est donc affectée à la variable X1, et le caractère suivant C du flux de données est affecté à la variable X2. La chaîne BAC est enregistrée dans le dictionnaire à l'adresse h(BAC) en association avec le code $2^N+2$ et le compteur CPT est incrémenté. Le code $2^N$ associé à la chaîne BA est délivré en sortie et le caractère C est affecté à la variable X1. Le caractère suivant A du flux de données est affecté à la variable X2 et la chaîne CA est recherchée dans le dictionnaire. Elle n'y figure pas, et y est donc enregistrée à l'adresse h(CA) en association avec le code $2^N+3$, Le compteur CPT est incrémenté, le code "2" associé au caractère C est délivré en sortie et le caractère A est affecté à la variable X1. Le caractère suivant B du flux de données est affecté à la variable X2 et la chaîne AB est trouvée dans le dictionnaire. Elle est donc affectée à la variable X1, et le caractère suivant A du flux de données est affecté à la variable X2. La chaîne ABA est enregistrée dans le dictionnaire à l'adresse h(ABA) en association avec le code $2^N+4$ et le compteur CPT est incrémenté. Le code $2^N+1$ associé à la chaîne AB est délivré en sortie. Enfin, le caractère A est affecté à la variable X1, et le code "0" qui lui est associé est délivré en sortie.

Ainsi le flux des données comprimées délivré est constitué par la succession de codes "1;0;$2^N$;2;$2^N+1$;0".

La figure 3A représente l'état du dictionnaire de compression à la suite de la compression du flux de données "BABACABA". Il comporte donc aux adresses h(A), h(B) et h(C) les caractères A, B et C qui sont respectivement associés aux codes 0, 1 et 2, et aux adresses h(BA), h(AB), h(BAC), h(CA) et h(ABA) les chaînes BA, AB, BAC, CA et ABA, qui sont respectivement associées aux codes $2^N$, $2^N+1$, $2^N+2$, $2^N+3$ et $2^N+4$. La figure 3B donne une représentation de ce même dictionnaire sous une forme arborescente. L'arbre comporte trois noeuds appelés noeud racines A, B et C. Le noeud racine B a pour fils un noeud A qui a lui même pour fils un noeud C appelé noeud feuille car il n'a aucun fils. Le noeud racine A a pour fils un noeud B qui a lui même pour fils un noeud feuille A. Et le noeud racine C a pour fils un noeud feuille A.

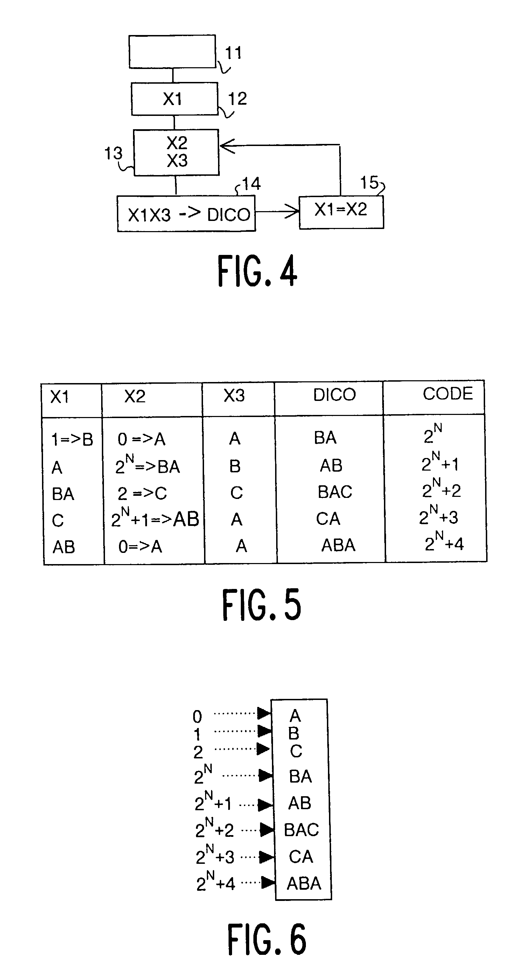

La figure 4 est un organigramme d'une procédure de décompression de type LZW. Conformément à la figure 4, les étapes fondamentales d'une telle procédure sont les suivantes:

- L'étape 11 correspond à l'enregistrement préalable des $2^N$ caractères de l'alphabet dans le dictionnaire et à l'initialisation du compteur à la valeur $2^N$.
- L'étape 12 consiste à lire le code reçu. Ce code reçu correspond à l'emplacement dans le dictionnaire de décompression du caractère ou de la chaîne de caractères associé. Ce caractère ou cette chaîne de caractères est affecté à une variable X1.
- L'étape 13 consiste à lire le code reçu suivant, et à affecter à une variable X2 le caractère ou la chaîne de caractères correspondant. Ce caractère ou le premier caractère de cette chaîne de caractères est affecté à une variable X3.
- L'étape 14 consiste à construire la chaîne de caractères X1X3, à l'enregistrer à l'adresse CPT dans le dictionnaire de décompression puis à incrémenter la valeur du compteur CPT.
- L'étape 15 consiste à affecter à la variable X1 le contenu de la variable X2. A l'issu de cette étape, la procédure reprend à l'étape 13.

La figure 5 décrit un exemple d'application d'une telle procédure au flux de données comprimées "1;0;$2^N$;2;$2^N+1$;0". Les caractères A, B et C sont préalablement enregistrés dans le dictionnaire aux adresses 0, 1 et 2, et le compteur CPT est initialisé à la valeur $2^N$. Le premier code reçu "1" est lu, et le caractère B, enregistré dans le dictionnaire à l'adresse 1, est affecté à la variable X1. Le code suivant "0" est lu et le caractère A, enregistré dans le dictionnaire de décompression à l'adresse "0", est affecté aux variables X2 et X3. La chaîne X1X3 c'est-à-dire la chaîne BA est construite dans le dictionnaire de décompression à l'adresse $2^N$. Le compteur CPT est incrémenté et le caractère "A" est affecté à la variable X1. Le code suivant "$2^N$" est lu et la chaîne BA enregistrée à cette adresse dans le dictionnaire est affectée à la variable X2. Le premier caractère B de cette chaîne est affecté à la variable $X_3$. La chaîne AB est enregistrée dans le dictionnaire de décompression à l'adresse $2^N+1$, le compteur CPT est incrémenté, et la chaîne BA est affectée à la variable X1. Le code suivant "2" est lu et le caractère "C", enregistré à cette adresse dans le dictionnaire, est affecté aux variables X2 et X3. La chaîne BAC est enregistrée dans le dictionnaire à l'adresse $2^N+2$, le compteur est incrémenté et le caractère C est affecté à la variable X1. Le caractère suivant "$2^N+1$" est lu et la chaîne AB enregistrée à cette adresse dans le dictionnaire est affectée à la variable X2. Le premier caractère "A" de cette chaîne est affecté à la variable X3. La chaîne CA est enregistrée dans le dictionnaire à l'adresse $2^N+3$, le compteur est incrémenté et la chaîne AB est affectée à la variable X1. Le code suivant "0" est lu et le caractère A enregistré à l'adresse "0" dans le dictionnaire est affecté aux variables X2 et $X_3$. La chaîne ABA est enregistrée dans le dictionnaire à l'adresse $2^N+4$ et le compteur est incrémenté.

La figure 6 représente l'état du dictionnaire de décompression à la suite de cette opération de décompression. Il comporte aux adresses 0, 1 et 2 les caractères A, B et C respectivement et aux adresses $2^N$ à $2^N+4$ les chaînes de caractères BA, AB, BAC, CA et ABA.

Conformément à cette procédure, un dictionnaire de compression comporte donc pour chaque chaîne de caractères enregistrée, d'une part la chaîne elle-même et d'autre part le code qui lui est associé.

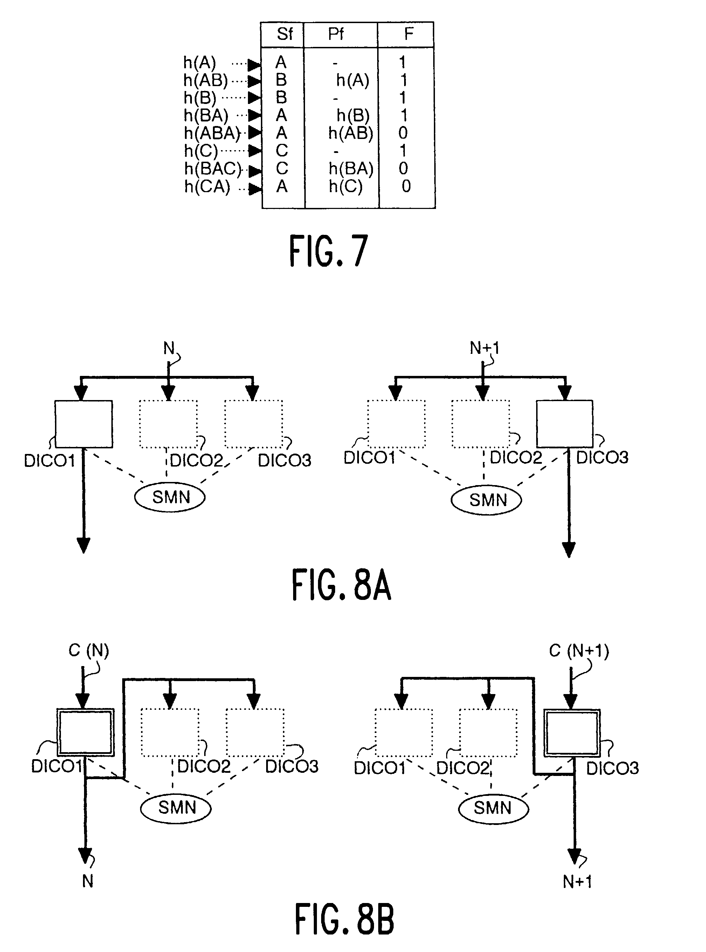

Un dictionnaire tel qu'utilisé dans la présente invention est représenté à la figure 7. Il se compose de mots de 32 bits. Chaque chaîne de caractères étant enregistrée sous forme d'un suffixe constitué par un caractère, et d'un préfixe constitué par un pointeur vers un autre élément du dictionnaire:

- les N premiers bits sont utilisés pour coder le suffixe (ici N est choisi égal à 8),
- les P bits suivants (P est compris entre 9 et 15 dans cet exemple de réalisation) sont utilisés pour coder le préfixe, c'est-à-dire l'adresse dans le dictionnaire du père de la chaîne,
- les 9 bits suivants sont utilisés pour coder le nombre de fils de la chaîne (ce nombre peut varier de 0 à $2^N$ où $2^N$ est la taille de l'alphabet, c'est-à-dire qu'il peut prendre 257 valeurs différentes si les caractères de l'alphabet sont codés sur 8 bits) un code spécifique (tous les bits à 1 par exemple) étant réservé pour indiquer que l'emplacement dans le dictionnaire est libre,
- et enfin les 15-P bits restants sont inutilisés.

La figure 7 représente l'état d'un dictionnaire selon l'invention en reprenant l'exemple traité sur la figure 2. Les colonnes contiennent respectivement le suffixe Sf, le préfixe Pf et le nombre de fils F de la chaîne correspondante.

D'après la figure 7, un tel dictionnaire comporte respectivement aux adresses h(A), h(B) et h(C) les caractères A, B et C (suffixes A, B et C, et pas de préfixe) qui ont chacun un fils (AB, BA et CA respectivement). Il comporte de plus aux adresses h(AB), h(ABA), h(BA), h(BAC) et h(CA) respectivement les chaînes de caractères AB (préfixe h(A), suffixe B), ABA (préfixe h(AB), suffixe A), BA (préfixe h(B), suffixe A), BAC (préfixe h (BA), suffixe C) et CA (préfixe h(C), suffixe A), les chaînes AB et BA ayant chacune un fils (ABA et BAC respectivement).

L'une des conséquences de l'invention est que les dictionnaires de compression et de décompression sont identiques, et que les procédures de compression et de décompression sont également identiques. En effet, conformément à l'invention le résultat de la compression du flux de données "BABACABA" est le flux de données comprimées "h(A), h(B), h(AB), h(C), h(BA)". Et l'opération de décompression consiste à lire dans le dictionnaire les données enregistrées aux adresses reçues, à reconstituer le flux de données initial et à appliquer l'opération de compression sur ce flux de données de façon à mettre à jour le dictionnaire.

L'utilisation d'un tel dictionnaire permet de réduire de façon notable la taille mémoire du dictionnaire. En effet, les tailles $T_{AA}$ et $T_{INV}$ d'un dictionnaire classique et d'un dictionnaire selon l'invention sont données par les expressions suivantes:

$$T_{AA} = (P + N + P) \times (2^P - 256)$$

$$T_{INV} = (P + N + n) \times (2^P - 256)$$

Ainsi, si n (nombre de bits nécessaires pour coder le nombre de fils d'un noeud du dictionnaire) est égal à N + 1, si N (nombre de bits sur lesquels les caractères d'entrée sont codés) est choisi égal à 8 et si P (nombre de bits sur lesquels les mots de code sont codés) est choisi égal à 14, un dictionnaire selon l'invention occupe 20% de mémoire de moins qu'un dictionnaire classique.

Dans la pratique, les chaînes n'ont jamais $2^N$ fils et n peut donc être réduit à 4 ou 5 bits et le gain en taille mémoire pour le dictionnaire est nettement supérieur.

D'autre part, l'invention utilise une fonction de hachage h permettant d'attribuer un emplacement à une chaîne (ou de rechercher l'emplacement d'une chaîne dans le dictionnaire) parmi un nombre limité NB de possibilités. Un exemple d'une telle fonction de hachage est donné ci-dessous pour une chaîne de caractères composée d'un préfixe x1 (caractère ou chaîne de caractères) et d'un suffixe x2 (caractère):

$$y1 = x2 \oplus (x1 << (P-N))$$

$$y2 = y1 \oplus (y1 << (P-N)) \oplus (y1 >> (P-N))$$

$$y3 = y2 \% (2^P - 2^N \pm k)$$

$$h(x1x2) = (y3 + i \% (2^P - 2^N))$$

où:

- i est compris entre 0 et NB-1 et correspond au numéro de l'emplacement essayé,
- $2^P-2^N$ est le nombre de chaînes de caractères pouvant être enregistrées dans le dictionnaire,
- k est un petit nombre (- 2, - 1, 1, 2 ou 3 par exemple),
- et les opérateurs ont les -significations suivantes:

　　<<j :　　décalage de j bits vers la gauche
　　>>j :　　décalage de j bits vers la droite
　　$\oplus$ :　　opération logique "OU Exclusif" bit à bit
　　%j :　　modulo j.

Ainsi, si la première position h(x1x2) obtenue pour i=0 est occupée (ou si elle ne correspond pas à la chaîne recherchée) la fonction est relancée après avoir incrémenté la valeur de i, et ce tant que i est inférieur à la limite NB (NB est par exemple fixé à 4).

Si tous les emplacements ainsi obtenus sont occupés, on cherche alors à écraser l'un d'eux au profit de la chaîne à enregistrer. L'emplacement écrasé est alors le premier emplacement rencontré qui n'a aucun fils parmi les NB emplacements explorés et le champ "nombre de fils" du père de la chaîne écrasée doit être décrémenté. Il est ainsi possible de mettre le dictionnaire à jour continûment en effaçant les caractères des fins des chaînes ce qui permet de perdre le moins d'informations possible. Si tous les NB emplacements ont au moins un fils, la chaîne à enregistrer est abandonnée.

Les dictionnaires de compression et de décompression étant construit symétriquement en suivant une même procédure, il est en effet possible d'abandonner certaines informations. Statistiquement 10% seulement des informations enregistrées dans le dictionnaire sont réutilisées de telle sorte que l'abandon de certaines informations est sans conséquence sur le taux de compression.

D'autre part, la compression des données pose le problème du choix du dictionnaire. Un petit dictionnaire contient peu de mots, mais ces mots sont courts de telle sorte que si le mot recherché n'est pas dans le dictionnaire, l'expansion et donc la baisse du taux de compression est faible. En revanche dans un grand dictionnaire, on a plus de chance de trouver le mot recherché, mais, les codes étant plus longs, la baisse du taux de compression est sensible lorsqu'on ne le trouve pas. Par exemple, un codage sur 9 bits qui correspond à un petit dictionnaire est bien adapté pour des données présentant des redondances à court terme, tandis qu'un codage sur un nombre plus important de bits est mieux adapté si les données présentent des redondances à long terme. L'invention permet dans un autre mode de réalisation d'utiliser plusieurs dictionnaires de différentes tailles et de choisir pour la compression/décompression celui qui à un moment donné est le plus efficace.

Pour cela, le flux de données est découpé en blocs de Q caractères. L'opération de compression est réalisée à partir de chaque dictionnaire, et les résultats obtenus en termes de taux de compression sont comparés de façon à sélectionner le dictionnaire maître pour la compression du bloc suivant. Seules les données comprimées par le dictionnaire maître sont délivrées. L'opération de décompression est réalisée par le dictionnaire maître pour le bloc courant. Puis une opération de compression est réalisée sur le bloc décomprimé à partir de chacun des dictionnaires esclaves. Les résultats obtenus avec chacun des dictionnaires sont ensuite comparés pour sélectionner le dictionnaire maître pour le bloc suivant.

Cette méthode permet une adaptation rapide aux données d'entrée à comprimer, ce qui assure une augmentation significative du taux de compression. A titre d'exemple, les données sont avantageusement découpées en blocs de 40 à 100 octets, notamment pour des applications de transmission par petits paquets comme c'est le cas pour les réseaux de transmission ATM ou X25.

La figure 8 représente schématiquement une telle procédure. Le dictionnaire DICO1 est maître pour la compression (figure 8A) et la décompression (figure 8B) du bloc N. Les performances des trois dictionnaires DIC01, DIC02 et DIC03 sont comparées par un circuit SMN à la fin du traitement du bloc N de façon à sélectionner le dictionnaire maître pour le traitement du bloc N+1. Sur l'exemple de la figure 8, c'est le dictionnaire DIC03 qui devient maître pour le bloc N+1.

A titre d'exemple, de bons rapports taux/débit sont obtenus en utilisant un petit dictionnaire (P=10 bits par exemple) et un grand dictionnaire (P=14 bits par exemple).

D'autre part, il est également intéressant d'implanter un mode de compression transparent, selon cette même procédure, sous forme d'un troisième dictionnaire, dit dictionnaire transparent, qui est en fait de taille nulle. Ce mode de réalisation présente l'avantage de ne pas impliquer l'envoi de code de contrôle dans le flot de données pour indiquer le passage d'un mode de compression à un mode transparent.

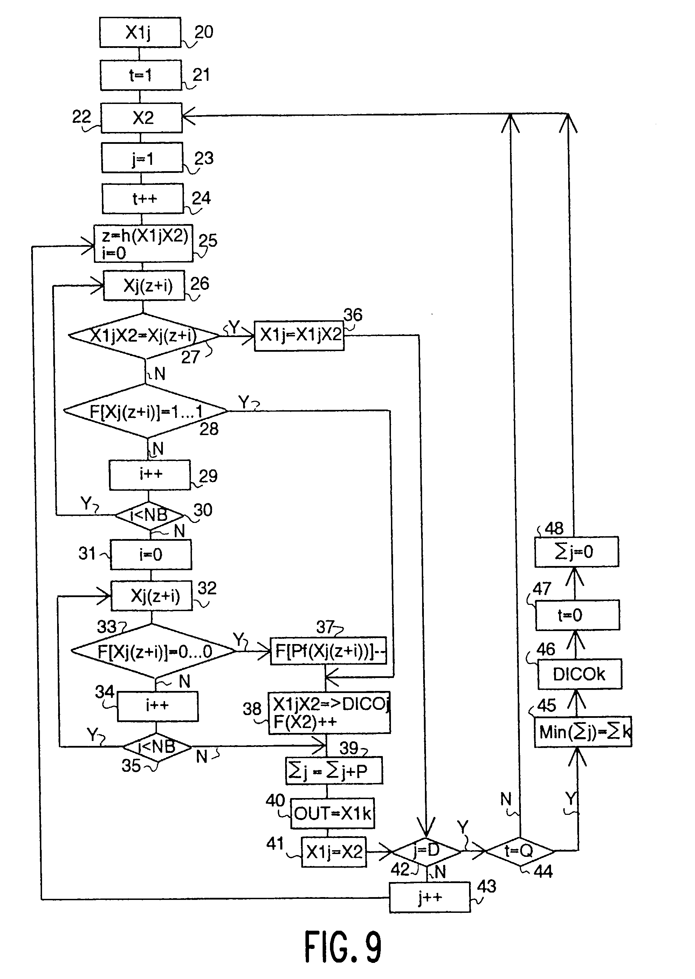

La figure 9 donne un exemple d'organigramme d'une procédure de compression utilisée dans un système selon l'invention. La signification des différentes étapes de cette procédure est donnée ci-dessous:

- A l'étape 20, le premier caractère du flux de données est lu et affecté aux variables X1j où j prend les valeurs entières 1 à D, D étant le nombre de dictionnaires utilisés.

- A l'étape suivante 21, la variable t est initialisée à 1. Cette variable est utilisée pour comptabiliser le nombre de caractères traités au cours d'un bloc. Elle varie donc de 1 à Q.

- L'étape suivante 22 consiste à lire le caractère suivant du flux de données et à l'affecter à une variable X2.

- L'étape suivante 23 consiste à initialiser la variable j à 1.

- L'étape suivante 24 consiste à incrémenter la variable t.

- L'étape suivante 25 consiste à calculer le résultat de la fonction de hachage h appliquée à la chaîne X1jX2, Ce résultat est affecté à la variable z. Puis une variable i est initialisée à la valeur 0.

- L'étape suivante 26 consiste à lire le contenu du dictionnaire DICOj à l'emplacement z+i. Le résultat de cette lecture est affecté à la variable Xj(z+i).

- A l'étape suivante 27, on compare le contenu des variables X1jX2 et Xj(z+i). S'il est identique, le fonctionnement se poursuit à l'étape 36. Sinon, il se poursuit à l'étape 28.

- L'étape 28 consiste à tester si l'emplacement z+i du dictionnaire DICOj est libre. Si c'est le cas, la chaîne de caractères X1jX2 va pouvoir être écrite à cet emplacement dans le dictionnaire DICOj, et le fonctionnement se poursuit à l'étape 38. Sinon, il se poursuit à l'étape 29 pour tester un emplacement de replis.

- L'étape 29 consiste à incrémenter la variable i.
- L'étape suivante 30 permet de tester si la variable i est inférieure à NB, NB étant le nombre de position de replis autorisées. Si c'est le cas, le fonctionnement reprend à l'étape 26 avec la nouvelle valeur de la variable i. Sinon, toutes les positions de replis ont été essayées et aucune n'est libre. Il s'agit donc de rechercher si l'un des emplacements de replis correspond à une feuille ce qui autoriserait à l'écraser pour enregistrer la chaîne $X1jX2$. Pour cela, le fonctionnement se poursuit à l'étape 31.
- L'étape 31 consiste à réinitialiser la variable i à 0.
- L'étape suivante 32 consiste à lire le contenu $Xj(z+i)$ du dictionnaire DICOj à l'emplacement $z+i$.
- l'étape suivante 33 consiste à vérifier si la chaîne $Xj(z+i)$ a ou non des fils. Si elle n'en a pas, le fonctionnement passe à l'étape 37. sinon il se poursuit à l'étape 34.
- A l'étape 34, la variable i est incrémentée.
- L'étape suivante 35 permet de tester si la variable i est inférieure à NB. Si c'est le cas le fonctionnement reprend à l'étape 32. Sinon, aucun des emplacements de replis n'étant disponible, la chaîne de caractères $X1jX2$ doit donc être abandonnée. Le fonctionnement se poursuit donc à l'étape 39,
- L'étape 36 consiste à affecter à la variable X1j la chaîne de caractères $X1jX2$. Le fonctionnement se poursuit ensuite à l'étape 42.
- L'étape 37 consiste à décrémenter le champ fils F du père de la chaîne écrasée $Xj(z+i)$.
- L'étape suivante 38 consiste à inscrire la chaîne de caractères $X1jX2$ dans le dictionnaire DICOj à l'emplacement $z+i$. Cette étape consiste également à incrémenter le champ "nombre de fils" du père X2 de la chaîne enregistrée $X1jX2$.
- A l'étape suivante 39, la variable $\Sigma j$ est mise à jour. Cette variable représente le nombre de bits qui sont transmis ou qui auraient été transmis par le dictionnaire DICOj s'il avait été maître pendant le traitement du bloc courant. Elle doit donc être augmentée de P, taille des codes émis, à chaque fois qu'un code est ou serait transmis.
- L'étape suivante 40 consiste à émettre le code correspondant à la chaîne ou au caractère X1j, si le dictionnaire DICOj est maître.
- L'étape suivante 41 consiste à affecter le caractère X2 à la variable X1j.
- L'étape suivante 42 est un test sur la valeur de la variable j. Si j=D, le fonctionnement se poursuit à l'étape 44. Sinon il se poursuit à l'étape 43.
- A l'étape 43 la variable j est incrémentée, puis le fonctionnement reprend à l'étape 25.
- L'étape 44 est un test sur la valeur de la variable t. Si t=Q, un bloc entier a été traité, et il s'agit de comparer les résultats de compression obtenus avec chacun des D dictionnaires. Pour cela le fonctionnement se poursuit à l'étape 45. Sinon, le fonctionnement reprend à l'étape 22.

- L'étape 45 consiste à rechercher la valeur k pour laquelle $\Sigma k$ est minimum parmi les D valeurs possibles.
- L'étape suivante 46 consiste à déclarer le dictionnaire DICOk comme dictionnaire maître.
- L'étape suivante 47 consiste à réinitialiser la valeur de la variable t à 0.
- L'étape suivante 48 consiste à réinitialiser la valeur des variables $\Sigma j$ à 0. Puis, le fonctionnement reprend à l'étape 22 de façon à traiter le bloc suivant de caractères.

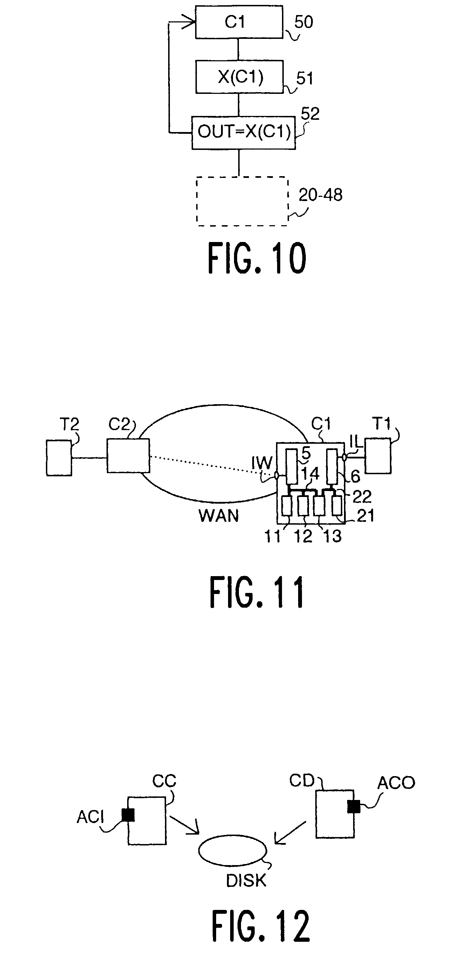

La figure 10 donne un organigramme d'une procédure de décompression de données. A l'étape 50 le premier code C1 de la suite de codes SC à décomprimer est lu et effacé de la suite de codes SC. L'étape suivante 51 consiste à lire dans le dictionnaire maître (DICOk) la chaîne enregistrée à l'emplacement indiqué par le code C1. A l'étape suivante 52, cette chaîne est délivrée en sortie de façon à reconstituer le flux de données d'entrée. Puis le fonctionnement reprend à l'étape 50. Le flux de données d'entrée ainsi obtenu est alors traité conformément à la procédure de compression exposée ci-dessus (case 20 à 48) de façon à mettre à jour les D dictionnaires et à sélectionner à la fin du traitement de chaque bloc de Q caractères le dictionnaire DICOk qui sera le dictionnaire maître pour le bloc suivant.

La figure 11 représente un exemple de système de transmission selon l'invention. Conformément à la figure 11 un tel système de transmission comporte un réseau WAN de type X25 constitué de deux commutateurs C1 et C2. Ces commutateurs C1 et C2 sont respectivement reliés à des terminaux T1 et T2. Ainsi, une communication peut être établie entre les deux terminaux T1 et T2 au travers du réseau WAN par l'intermédiaire des commutateurs C1 et C2 qui jouent le rôle d'émetteur ou de récepteur selon qu'ils transmettent des données en provenance d'un terminal vers le réseau WAN ou qu'à l'inverse ils transmettent des données en provenance du réseau WAN vers un terminal.

Chaque commutateur est doté d'une fonction de compression/décompression conforme à l'invention de façon à comprimer les données qu'il reçoit en provenance d'un terminal avant de les retransmettre sur le réseau WAN, et à décomprimer les données qu'il reçoit en provenance du réseau WAN avant de les retransmettre à un terminal.

Le commutateur C1 est représenté de façon détaillée. Il comporte une interface IW vers le réseau WAN et une interface IL vers le terminal T1. L'interface IW vers le réseau WAN est relié à un microprocesseur 5 qui est par exemple un 68302 de Motorola. Ce microprocesseur 5 est lui-même relié par un bus 14 à une mémoire 11 dite mémoire de configuration de l'équipement et à une mémoire statique 12 qui contient les instructions de fonctionnement du microprocesseur 5, notamment celles nécessaires à la mise en place de l'invention, et à une mémoire vive 13 contenant des données. L'interface IL est reliée à un processeur de communication 6.

A titre d'exemple, lorsque le terminal T1 est une station Ethernet d'un réseau local, ce processeur de communication 6 est par exemple formé à partir d'un transmetteur Intel 82503 et d'un processeur Intel 82596DX.

Ce processeur de communication 6 est lui-même relié par un bus 22 à une mémoire statique 21 contenant les instructions de fonctionnement du processeur de communication 6 et à la mémoire de données 13 précitée.

L'invention est applicable à d'autres types de système de transmission. Elle est particulièrement bien adaptée pour des systèmes à haut débit lorsqu'elle est mise en oeuvre sous forme de circuit spécifique de type ASIC.

La figure 12 enfin représente schématiquement un système de stockage de données comprimées sur un disque DISK. Le flux de données d'entrée à stocker est reçu sur un accès ACI. Il est comprimé par un circuit CC qui est un ensemble à microprocesseur dont les instructions sont semblables à celles décrites sur l'organigramme de la figure 9. Puis il est stocké sur le disque DISK. Les données comprimées stockées sur le disque DISK sont lues et décomprimées par un circuit DC qui est un ensemble à microprocesseur dont les instructions sont semblables à celles décrites sur l'organigramme de la figure 10. puis les données décomprimées correspondantes sont délivrées sur un accès AC0.

## Revendications

1. Système de compression/décompression comportant:

    - un accès (IL, ACI) pour recevoir un flux de données,
    - des moyens de compression (20 à 48) dudit flux de données formés de moyens de découpage (20, 24, 36 41) dudit flux de données en chaînes de caractères et de moyens de construction d'un dictionnaire (25 à 35, 37, 38) associant un code à chacune desdites chaînes de caractères,
    - des moyens de délivrance (IW, 40) sur un support intermédiaire (WAN, DISK) d'un flux comprimé constitué à partir desdits codes,
    - des moyens de décompression (50 à 52, 20 à 48) du flux de données en provenance dudit support intermédiaire (WAN, DISK),
    - un accès (IL, ACO) pour fournir le flux de données décomprimé,

    caractérisé en ce que ledit code est constitué par l'adresse dans le dictionnaire de la chaîne de caractères associée.

2. Système de compression/décompression selon la revendication 1, caractérisé en ce que lesdits moyens de construction du dictionnaire sont notamment formés:

    - de moyens (25) pour attribuer à une chaîne un premier emplacement dans le dictionnaire,
    - de moyens (28, 35) pour rechercher un nombre limité (NB) d'emplacements de replis dans le cas où ledit premier emplacement ne serait pas disponible.

3. Système de compression/décompression selon la revendication 2 caractérisé en ce que lesdits moyens de construction du dictionnaire sont de plus formés:

    - de moyens (38) pour enregistrer chaque chaîne dans le dictionnaire sous forme d'un suffixe (Sf) et d'un préfixe (Pf) constitué par un pointeur vers un autre élément du dictionnaire,
    - de moyens (37, 38) pour associer de plus à chaque chaîne de caractères le nombre de ses fils,
    - et de moyens (31 à 35) pour rechercher dans le dictionnaire, lorsque pour une nouvelle chaîne de caractères aucun des emplacements de replis n'est disponible, une chaîne de caractères qui n'a pas de fils et des moyens (37, 38) pour la remplacer par ladite nouvelle chaîne de caractères.

4. Système de compression/décompression selon l'une des revendications 1 à 3, caractérisé en ce que les moyens de décompression sont notamment formés de moyens de mise à jour du dictionnaire qui reprennent les moyens de découpage du flux de données et de construction du dictionnaire utilisés pour la compression.

5. Système de compression/décompression selon l'une des revendications 1 à 3, caractérisé en ce que lesdits moyens de compression comportent:

    - une pluralité de dictionnaires (DIC01, DIC02, DIC03) construits en parallèle,
    - des moyens (SMN, 45) de comparaison régulière de l'efficacité de chacun d'eux sur les données traitées,
    - et des moyens (SMN, 45, 46) de sélection du dictionnaire le plus efficace, dit dictionnaire maître, pour délivrer ledit flux comprimé à venir,

    et en ce que les moyens de décompression sont notamment constitués par:

    - des moyens (20 à 43) de mise à jour en parallèle de chacun des dictionnaires qui reprennent les moyens de découpage du flux de données et de construction desdits dictionnaires utilisés pour la compression,

- des moyens (SMN, 45) de comparaison régulière de l'efficacité de chacun d'eux sur les données traitées,

- et des moyens (SMN, 45, 46) de sélection du dictionnaire le plus efficace, dit dictionnaire maître, pour décomprimer les données à venir.

6. Système de compression/décompression selon la revendication 5, caractérisé en ce que l'un desdits dictionnaires est un dictionnaire de taille nulle utilisé pour délivrer des données sans compression.

7. Système de compression/décompression selon l'une des revendications 1 à 6, caractérisé en ce que ledit support intermédiaire est un support de transmission de données (WAN).

8. Système de compression/décompression selon l'une des revendications 1 à 6, caractérisé en ce que ledit support intermédiaire est un support de stockage de données.

9. Emetteur destiné à transmettre un flux de données comportant:

- des moyens de compression (20 à 48) dudit flux de données formés de moyens de découpage (20, 24, 36, 41) dudit flux de données en chaîne de caractères,

- et de moyens de construction d'un dictionnaire (25 à 35, 37, 38) associant un code à chacune desdites chaînes de caractères,

caractérisé en ce que ledit code est constitué par l'adresse dans le dictionnaire de la chaîne de caractères associée.

10. Récepteur destiné à recevoir un flux de données préalablement découpé en chaînes de caractères pour être comprimé, et qui comporte des moyens de décompression, caractérisé en ce que, ledit flux de données comprimé étant constitué des adresses dans un dictionnaire de compression desdites chaînes de caractères, lesdits moyens de décompression comportent;

- des moyens de lecture dans un dictionnaire de décompression des chaînes de caractères enregistrées aux dites adresses,

- des moyens de reconstitution du flux de données décomprimé,

- des moyens de compression du flux reconstitué pour mettre à jour ledit dictionnaire de décompression.

FIG. 1

| X1 | X2 | X1X2 | DICO | CODE | OUT |
|----|----|------|------|------|-----|
| B  | A  | BA   | BA   | $2^N$ | 1 |
| A  | B  | AB   | AB   | $2^N+1$ | 0 |
| B  | A  | BA   | -    | -    | - |
| BA | C  | BAC  | BAC  | $2^N+2$ | $2^N$ |
| C  | A  | CA   | CA   | $2^N+3$ | 2 |
| A  | B  | AB   | -    | -    | - |
| AB | A  | ABA  | ABA  | $2^N+4$ | $2^N+1$ |

FIG. 2

FIG. 3A

FIG. 3B

## FIG. 4

```
                    ┌──────────┐
                    │          │ ╮11
                    └──────────┘ ╯
                         │
                    ┌──────────┐
                    │   X1     │ ╮12
                    └──────────┘ ╯
                         │
                    ┌──────────┐
          13 ╭─────│   X2     │◄──────────┐
             ╯     │   X3     │           │
                    └──────────┘           │
                         │     ╭14    15 ╮ │
              ┌──────────────┐      ┌────────┐
              │ X1X3 -> DICO │─────►│ X1=X2  │
              └──────────────┘      └────────┘
```

## FIG. 4

| X1 | X2 | X3 | DICO | CODE |
|----|----|----|------|------|
| 1=>B | 0 =>A | A | BA | $2^N$ |
| A | $2^N$=>BA | B | AB | $2^N+1$ |
| BA | 2 =>C | C | BAC | $2^N+2$ |
| C | $2^N+1$=>AB | A | CA | $2^N+3$ |
| AB | 0=>A | A | ABA | $2^N+4$ |

## FIG. 5

```
    0      ····► A
    1      ····► B
    2      ····► C
  $2^N$    ····► BA
  $2^N+1$  ····► AB
  $2^N+2$  ····► BAC
  $2^N+3$  ····► CA
  $2^N+4$  ····► ABA
```

## FIG. 6

| | Sf | Pf | F |
|---|---|---|---|
| h(A) | A | - | 1 |
| h(AB) | B | h(A) | 1 |
| h(B) | B | - | 1 |
| h(BA) | A | h(B) | 1 |
| h(ABA) | A | h(AB) | 0 |
| h(C) | C | - | 1 |
| h(BAC) | C | h(BA) | 0 |
| h(CA) | A | h(C) | 0 |

## FIG. 7

## FIG. 8A

## FIG. 8B

FIG. 9

C1 — 50

X(C1) — 51

OUT=X(C1) — 52

20-48

# FIG. 10

T2  C2  C1  T1

IW

5

14

II

6

22

21

11  12  13

WAN

# FIG. 11

CC  CD  ACO

ACI

DISK

# FIG. 12

**Office européen des brevets**

# RAPPORT DE RECHERCHE EUROPEENNE

Numero de la demande

EP 96 20 0089

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| X | EP-A-0 573 208 (LEMPEL ET AL) <br> * page 12, ligne 52 - page 13, ligne 48; figure 10 * <br> --- | 1,4,9,10 | H03M7/30 |
| X | WO-A-95 01677 (CODEX INC.) <br> * page 6, ligne 5 - ligne 35; figure 1 * | 1-4,7,9 | |
| Y | * page 8, ligne 20 - page 11, ligne 2; figure 5 * <br> --- | 5 | |
| X | WO-A-90 00837 (BRITISH COMMUNICATIONS PUBLIC LIMITED) <br> * page 9, ligne 37 - page 15, ligne 19 * | 1-4,9 | |
| Y | * page 18, ligne 1 - ligne 21; figure 7 * <br> --- | 5 | |
| Y | US-A-4 876 541 (STORER) <br> * colonne 4, ligne 46 - ligne 52 * <br> * colonne 22, ligne 4 - ligne 36 * <br> ----- | 5 | |

**DOMAINES TECHNIQUES RECHERCHES (Int.Cl.6)**

H03M

Le présent rapport a été établi pour toutes les revendications

| Lieu de la recherche | Date d'achèvement de la recherche | Examinateur |
|---|---|---|
| LA HAYE | 1 Avril 1996 | Feuer, F |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)